# EUROPEAN PATENT SPECIFICATION

(11) **EP 2 937 930 B1**
(45) Date of publication and mention of the grant of the patent: **10.10.2018**
(21) Application number: 13864371.3
(22) Date of filing: 05.12.2013
(51) Int. Cl.: H01M 10/48, G01K 1/14, G01R 1/04, G01R 31/36, H01M 2/10, H01M 2/30, G01K 7/22, G01K 13/00

(54) **BATTERY STATE MONITORING DEVICE AND BATTERY MODULE PROVIDED WITH SAME**
VORRICHTUNG ZUR ÜBERWACHUNG DES BATTERIESTATUS UND BATTERIEMODUL DAMIT
DISPOSITIF DE CONTRÔLE DE L'ÉTAT DE CHARGE D'UNE BATTERIE ET MODULE BATTERIE DOTÉ D'UN TEL DISPOSITIF

(30) Priority: 19.12.2012 JP 2012277266; 27.09.2013 JP 2013201635
(43) Date of publication of application: 28.10.2015
(73) Proprietor: Mitsubishi Heavy Industries, Ltd., Tokyo 108-8215 (JP)
(72) Inventor: KITAMURA Tsuyoshi, Tokyo 108-8215 (JP); GOTO Mitsufumi, Tokyo 108-8215 (JP); SHIGEMIZU Tetsuro, Tokyo 108-8215 (JP); KAWAZOE Kohei, Tokyo 108-8215 (JP); MATSUDA Naohiko, Tokyo 108-8215 (JP); TAKATSUJI Hideyasu, Tokyo 108-8215 (JP); NISHIDA Takehiko, Tokyo 108-8215 (JP)
(74) Representative: Hoffmann Eitle
(86) International application number: PCT/JP2013/082731
(87) International publication number: WO 2014/097896

(56) References cited:
- WO-A1-2012/007428
- WO-A1-2012/137289
- WO-A1-2012/137289
- JP-A- H05 164 626
- JP-A- 2012 009 411
- JP-A- 2012 177 589
- US-A1- 2011 177 368

## Description

### Technical Field

The present invention relates to a battery state monitoring device and a battery module including the same.

### Background Art

In a secondary battery, such as a lithium ion battery, in order to operate the battery successfully and safely, it is necessary to measure a voltage between terminals, battery temperature, and the like. Based on the measurement result, control of battery charge and discharge and control to transit the voltage and temperature to a normal range are performed.

Here, as a device for measuring the battery temperature, a device including a substrate and a thermistor, which is provided on the bottom side of the substrate with a sponge interposed therebetween and is disposed in contact with a battery can, has been proposed (refer to JP 2012-177589, hereafter PTL 1).

In this device, the thermistor is biased to the battery can side by the sponge provided on the bottom surface of the substrate and is brought into contact with the battery can, thereby performing the measurement of battery temperature.

A further document is WO 2012/137289 A1, which refers to an electrical storage module provided with a plurality of battery cells. The module further comprises a temperature detector, which is provided on the wiring and detects the temperature of the battery cells.

### Summary of Invention

### Technical Problem

However, in the device disclosed in PTL 1 above, for example, when vibration occurs in the battery can or the like, contact between the thermistor and the outer surface of the battery can becomes unstable. Accordingly, the temperature of the battery may not be able to be measured accurately.

The present invention provides a battery state monitoring device capable of measuring the temperature of the battery stably and accurately and a battery module including the same.

### Solution to Problem

(1) According to the present invention, as defined in claim 1, a battery state monitoring device includes a substrate, a stator, and a temperature measuring element. In the substrate, a terminal insertion hole into which an electrode terminal of a battery is inserted is formed. The stator is formed of a heat conductive material, is provided around the terminal insertion hole, and is attached to the electrode terminal so as to be in contact with the electrode terminal in a state where the electrode terminal is inserted into the terminal insertion hole. The temperature measuring element is fixed to the substrate, and measures a temperature of the electrode terminal through the stator.
   According to the configuration described above, the stator is attached to the electrode terminal so as to be in contact with the electrode terminal by inserting the electrode terminal into the terminal insertion hole formed in the substrate. In addition, the temperature measuring element that measures the temperature of the electrode terminal has a structure that is not in direct contact with the battery fixed to the substrate. For this reason, even if vibration occurs in the battery, it is possible to maintain the state where the stator and the electrode terminal are in stable contact with each other. Therefore, since the stator is formed of a heat conductive material, the temperature measuring element can stably and accurately measure the temperature of the electrode terminal, that is, the temperature of the battery, through the stator.
(2) In the battery state monitoring device of (1) described above, the stator includes according to the present invention a pressing portion that presses the electrode terminal radially inward so as to be in contact with the electrode terminal in a state where the electrode terminal is inserted into the terminal insertion hole.
   According to the configuration described above, since the pressing portion presses the electrode terminal radially inward, it is possible to reliably maintain the contact state between the pressing portion and the electrode terminal. Therefore, it is possible to measure the temperature of the battery more stably and accurately.
(3) In the battery state monitoring device of (2) described above, the stator includes three pressing portions that are disposed along an outer periphery of the electrode terminal in a state where the electrode terminal is inserted into the terminal insertion hole.
   According to the configuration described above, since the three pressing portions press the electrode terminal radially inward from the outer peripheral side of the electrode terminal, it is possible to more reliably maintain the contact state between the pressing portions and the electrode terminal. Therefore, it is possible to measure the temperature of the battery more stably and accurately.
(4) In the battery state monitoring device of any one of (1) to (3) described above, the temperature measuring element is provided on a surface facing the battery of one of a top and bottom surfaces of the substrate.
   According to the configuration described above, the temperature measuring element is provided on a surface facing the battery of one of the top and bottom surfaces of the substrate. Therefore, for example, when a member connecting a plurality of batteries to each other is attached to the surface of the substrate not facing the battery side, there is no possibility that the temperature measuring element will be damaged due to being in contact with the member. Therefore, since it is possible to maintain the healthy state of the temperature measuring element, it is possible to measure the temperature of the battery stably and accurately.
(5) The battery state monitoring device of any one of (1) to (4) described above may further include a stator connection end that is formed of a heat conductive material, is connected to the stator, and thermally connects the stator and the temperature measuring element to each other. Both of the temperature measuring element and the stator connection end are covered by an insulating material.
   According to the configuration described above, the temperature measuring element can measure the temperature of the battery through the stator connection end connected to the stator. In addition, since the temperature measuring element and the stator connection end are covered by the insulating material, it is possible to measure the temperature of the battery stably and accurately without being influenced by outside air or cooling air for cooling the battery, for example.
(6) The battery state monitoring device of any one of (1) to (4) described above may further include a stator connection end that is formed of a heat conductive material, is connected to the stator, and thermally connects the stator and the temperature measuring element to each other. The stator connection end is disposed on a side of the substrate with respect to the temperature measuring element in a thickness direction of the substrate, with an insulating material interposed therebetween.
(7) The battery state monitoring device of any one of (1) to (4) described above may further include a stator connection end that is formed of a heat conductive material, is connected to the stator, and thermally connects the stator and the temperature measuring element to each other. The stator connection end is disposed on a side opposite to a side of the substrate with respect to the temperature measuring element in a thickness direction of the substrate, with an insulating material interposed therebetween.
   According to the configuration described above, since the temperature measuring element is interposed between the substrate and the stator connection end, it is possible to reduce the influence of external environmental temperature.
(8) In the battery state monitoring device of any one of (5) to (7) described above, the temperature measuring element includes a main body and an end for connecting the main body to an outside. A width of the stator connection end in a direction parallel to the substrate is larger than a maximum size of the main body in the temperature measuring element.
   According to the configuration described above, since the thermal resistance of the stator connection end is reduced, heat is easily transferred from the electrode terminal to the temperature measuring element through the stator connection end. Therefore, since it is possible to reduce the time difference of the temperature change around the temperature measuring element with respect to the temperature change of the electrode terminal, it is possible to improve the temperature measurement responsiveness. In addition, the amount of heat flowing from the electrode terminal to the temperature measuring element side is increased. Therefore, it is possible to reduce the influence of external environmental temperature compared with a case where the width of the stator connection end is small.
(9) In the battery state monitoring device of any one of (1) to (8) described above, a gap portion is present between the electrode terminal and the stator, the electrode terminal and the stator facing each other so as to be separated from each other with the gap interposed therebetween. The battery state monitoring device includes a thermal conduction promoting member. The thermal conduction promoting member is disposed in the gap portion, is in contact with both of the electrode terminal and the stator, and is formed of a heat conductive material having a lower melting point than melting points of the electrode terminal and the stator.
   According to the configuration described above, since the thermal conduction promoting member formed of a heat conductive material is disposed in the gap portion between the electrode terminal and the stator, heat can be easily transferred from the electrode terminal to the stator. In addition, since the thermal conduction promoting member has a low melting point, the thermal conduction promoting member becomes soft in an early stage of the process in which the temperature of the electrode terminal rises. Therefore, since the contact between the thermal conduction promoting member and the electrode terminal, and the thermal conduction promoting member and the stator is increased, heat can be more easily transferred from the electrode terminal to the stator.
(10) In the battery state monitoring device of (9) described above, the thermal conduction promoting member is formed of an alloy containing Sn and Bi or In.
   According to the configuration described above, the melting point of the thermal conduction promoting member can be set to 150°C or lower.
(11) In the battery state monitoring device of any one of (1) to (10) described above, the stator is formed of an electrically conductive material, and forms a terminal for terminal potential measurement for measuring an electric potential of the electrode terminal.
   According to the configuration described above, since the stator is formed of an electrically conductive material, it is possible to accurately measure the temperature of the battery and to measure the voltage of the battery. Therefore, it is possible to measure the temperature of the battery and the voltage of the battery while suppressing the number of parts.
(12) According to a second aspect of the present invention, a battery module includes the battery state monitoring device according to any one of (1) to (10) and the battery.

According to the configuration described above, the stator is brought into contact with the electrode terminal by inserting the electrode terminal into the terminal insertion hole formed in the substrate. In addition, the temperature measuring element that measures the temperature of the electrode terminal is fixed to the substrate. Therefore, since the stator is formed of a heat conductive material, the temperature measuring element can stably and accurately measure the temperature of the electrode terminal, that is, the temperature of the battery, through the stator in a state in which the stator and the electrode terminal are in contact with each other.

### Advantageous Effects of Invention

According to the battery state monitoring device and the battery module including the same described above, it is possible to measure the temperature of the battery stably and accurately.

### Brief Description of Drawings

Fig. 1 is a schematic top view of a battery module according to an embodiment of the present invention.
Fig. 2 is a perspective view of a main part of a battery that forms the battery module according to an embodiment of the present invention.
Fig. 3 is a bottom view of a battery state monitoring device that forms the battery module according to an embodiment of the present invention.
Fig. 4 is an exploded cross-sectional view of a main part of the battery module according to an embodiment of the present invention.
Fig. 5 is a cross-sectional view of a main part of the battery module according to an embodiment of the present invention.
Fig. 6 is a cross-sectional view taken along the line A-A of Fig. 3.
Fig. 7 is a bottom view of a battery state monitoring device in a first modification example of an embodiment of the present invention.
Fig. 8 is a cross-sectional view taken along the line A-A of Fig. 7.
Fig. 9 is a cross-sectional view of a battery state monitoring device around a temperature measuring element in a second modification example of an embodiment of the present invention.
Fig. 10 is an exploded cross-sectional view of a main part of a battery module in a third modification example of an embodiment of the present invention.
Fig. 11 is a cross-sectional view of a main part of a battery module in the third modification example of an embodiment of the present invention.

### Description of Embodiments

Hereinafter, a battery module of an embodiment of the present invention will be described.

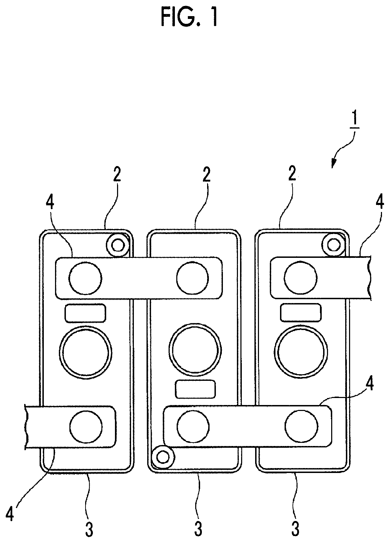

As shown in Fig. 1, a battery module 1 includes a plurality of batteries 2, a battery state monitoring device 3 for measuring the temperature or the like of the battery 2, and a bus bar 4 for electrically connecting the plurality of batteries 2 to each other. In the present embodiment, the battery 2 will be described by way of an example of a lithium ion secondary battery.

First, the battery 2 will be described.

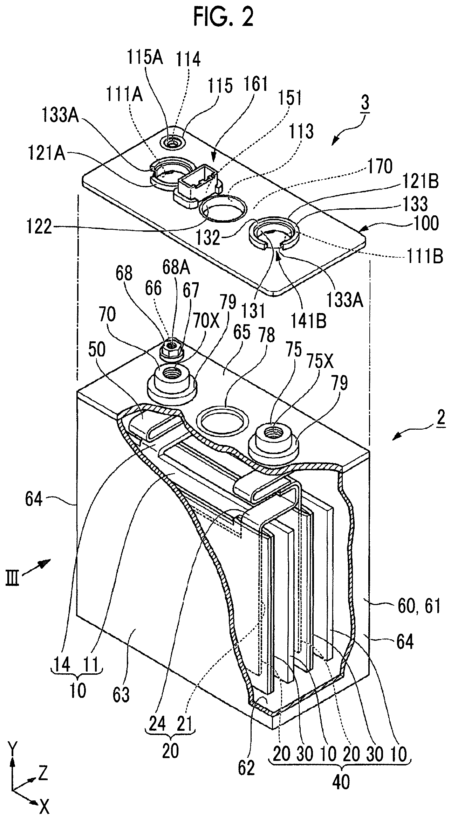

As shown in Fig. 2, the battery 2 includes a plurality of positive plates 10, a plurality of negative plates 20, a separator 30 that covers the negative plates 20, an electrolyte, and a metal battery case 60 for housing these.

The electrode plates 10 and 20 include plate bodies 11 and 21 and tabs 14 and 24 extending from the edges of cores of the plate bodies 11 and 21. The plate bodies 11 and 21 are formed by bonding an active material or the like on the rectangular core, such as aluminum foil and copper foil. The plate body 21 of the negative plate 20 is completely covered by the separator 30. A part of the tab 24 of the negative plate 20 is exposed from the separator 30.

A plurality of positive plates 10 and a plurality of negative plates 20, each of which is covered by the separator 30, are alternately laminated so that the tabs 14 and 24 protrude to the same side, thereby forming an electrode laminate 40.

In a state where the plurality of positive plates 10 and the plurality of negative plates 20 are laminated, the positive tab 14 and the negative tab 24 are aligned in a direction perpendicular to the lamination direction.

Here, a lamination direction in which the plurality of positive plates 10 and the plurality of negative plates 20 are laminated is assumed be a Z direction. A direction which is a direction perpendicular to the Z direction and in which the positive tab 14 and the negative tab 24 are aligned is assumed be an X direction. A direction perpendicular to the X and Z directions is assumed be a Y direction. As shown in Fig. 2, directions of the arrows of the XYZ coordinates are (+) side.

The battery case 60 includes a case body 61 and a lid 65 that closes the rectangular opening of the case body 61. A housing recess having a rectangular parallelepiped shape in which the electrode laminate 40 is housed is formed in the case body 61.

The case body 61 includes a pair of first side plates 63 having rectangular shapes and facing each other, a pair of second side plates 64 similarly having rectangular shapes and facing each other, and a rectangular bottom plate 62. The plates 62, 63, and 64 form a housing recess.

Here, the pair of first side plates 63 face each other in the Z direction. The pair of second side plates 64 face each other in the X direction. In addition, the opening of the case body 61 is formed on the (+)Y side with respect to the bottom plate 62.

The lid 65 has a rectangular plate shape corresponding to the shape of the rectangular opening of the case body 61. A positive terminal 70 and a negative terminal 75 are fixed to the lid 65 through an insulating material 79. Female screws 70X and 75X are formed in the positive terminal 70 and the negative terminal 75, respectively.

In the lid 65, a safety valve 78 that operates when the pressure in the battery case 60 becomes equal to or higher than a predetermined value is provided at an intermediate position of the positive terminal 70 and the negative terminal 75.

Here, the positive terminal 70, the negative terminal 75, and the safety valve 78 are aligned in the X-direction. In addition, the positive terminal 70 and the negative terminal 75 protrude toward the (+)Y side from the lid 65.

An inlet 66 for putting an electrolyte into the case body 61 is formed near the corner on the (+)Z side and the (-)X side among the four corners of the lid 65 having a rectangular plate shape. After the electrolyte is put into the battery case 60 from the inlet 66, a palate 67 is provided on the (+)Y side of the inlet 66, a bolt 68 is screwed into the palate 67, and the inlet 66 is sealed. A female screw 68A for the bolt 68 is formed in the palate 67.

In the present embodiment, the positive terminal 70 is formed of aluminum. The negative terminal 75 is formed of copper.

Next, a battery state monitoring device 3 for measuring the temperature or the like of the battery 2 configured as described above will be described in detail.

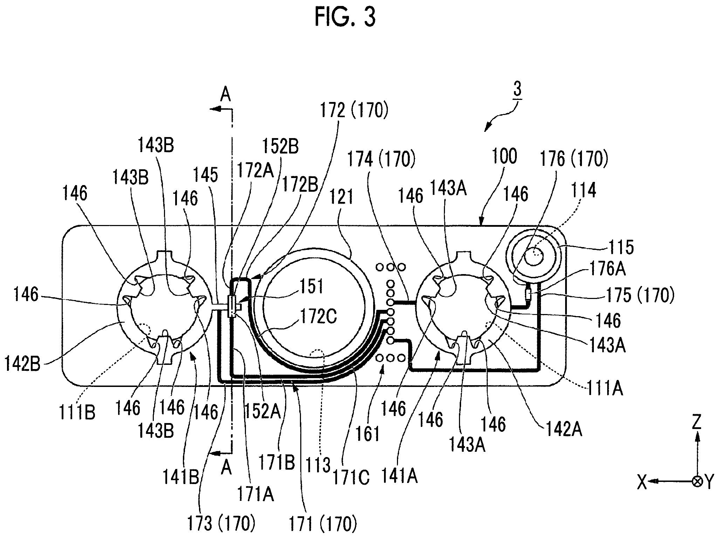

As shown in Figs. 2 and 3, the battery state monitoring device 3 includes a substrate 100, a positive side stator 141A and a negative side stator 141B (stator), a temperature measuring element 151 that measures the temperature of the negative terminal 75, a connector 161 provided on the substrate 100, and a plurality of wiring lines 170 connected to the connector 161. The positive side stator 141A and the negative side stator 141B (stator) are attached to the positive terminal 70 and the negative terminal 75 (electrode terminal) of the battery 2, respectively.

The substrate 100 is a plate-shaped member having an approximately rectangular shape. The length of the substrate 100 in the X direction is approximately the same as the length of the case body 61 in the X direction. The length of the substrate 100 in the Z direction is the same as the length of the case body 61 in the Z direction. The shape of the substrate 100 may be any shape that can be attached to the positive terminal 70 and the negative terminal 75, and may not be approximately the same as the shapes of the case body 61 in the X and Z directions.

The substrate 100 is disposed on the (+)Y side facing the lid 65 of the battery 2.

Here, the surface of the substrate 100 on the (+)Y side is assumed to be a top surface. The surface of the substrate 100 on the (-)Y side, which is a side on which the battery 2 is disposed, is assumed to be a bottom surface.

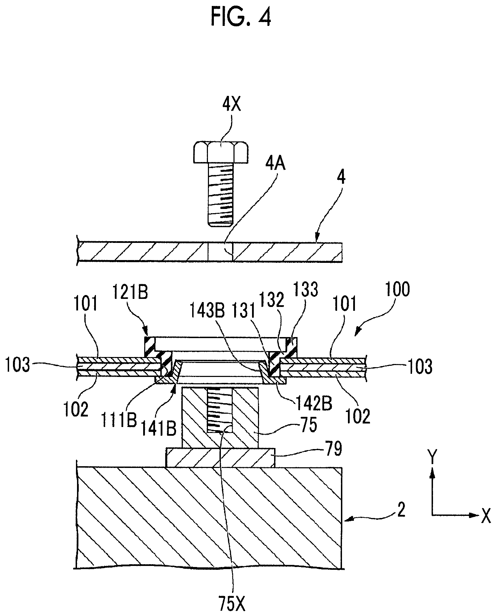

As shown in Fig. 4, the substrate 100 includes a surface layer 101 that forms the top surface, a bottom layer 102 that forms the bottom surface, and a shield layer 103 laminated between the surface layer 101 and the bottom layer 102.

The shield layer 103 is formed of an electrically conductive material. In the present embodiment, the shield layer 103 is formed of copper as an example of the electrically conductive material. The shield layer 103 is effective in having an effect of reducing noise that may affect the wiring lines 170. However, in the present embodiment, the shield layer 103 may be omitted.

As shown in Figs. 2 and 3, a positive side insertion hole 111A into which the positive terminal 70 is inserted and a negative side insertion hole 111B (terminal insertion hole) into which the negative terminal 75 is inserted are formed in the substrate 100. In the substrate 100, a safety valve hole 113 is formed at a position facing the safety valve 78 of the battery 2. Each of the positive side insertion hole 111A, the negative side insertion hole 111B, and the safety valve hole 113 is a through hole with an approximately circular opening. The safety valve hole 113 is effective since gas emitted upward from the safety valve 78 can be missed when the safety valve 78 operates in the battery 2. In the present embodiment, however, the safety valve hole 113 may be omitted.

In the substrate 100, a through hole 114 for injection is formed at a position corresponding to the inlet 66 formed in the lid 65. An edge member 115 formed of a conductor is provided along the edge of the through hole 114. A female screw 115A is formed in the edge member 115. In the present embodiment, it is not necessary to form the through hole 114 in the substrate 100.

As will be described in detail later, a bolt (not shown) is screwed into the female screw 115A of the edge member 115 and the female screw 68A of the bolt 68 of the palate 67 provided in the inlet 66 in a state where the battery state monitoring device 3 is attached to the battery 2.

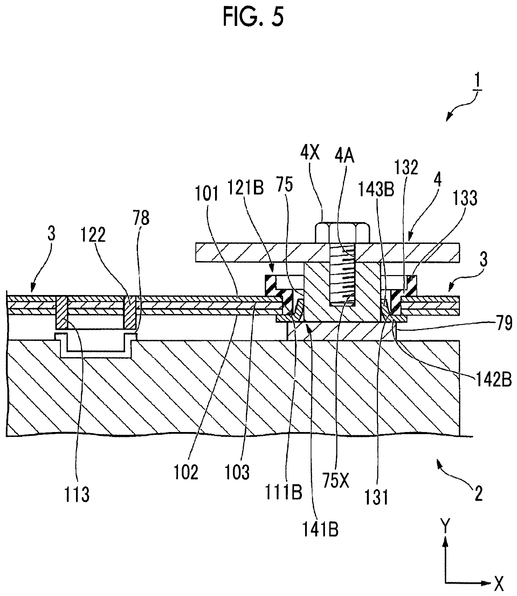

As shown in Figs. 2 and 5, the substrate 100 includes a positive side insulation protruding portion 121A, a negative side insulation protruding portion 121B (insulation protruding portion), and a cylindrical portion 122. The positive side insulation protruding portion 121A and the negative side insulation protruding portion 121B protrude toward the top surface side of the substrate 100, that is, toward the (+)Y side, from the periphery of the positive side insertion hole 111A and the negative side insertion hole 111B. The cylindrical portion 122 extends from the periphery of the safety valve hole 113 toward the opposite safety valve side, that is, toward the (-)Y side. The cylindrical portion 122 is formed of a high heat-resistant material. In the present embodiment, the cylindrical portion 122 may be appropriately omitted.

The negative side insulation protruding portion 121B is formed of an insulating material. In the present embodiment, the negative side insulation protruding portion 121B is formed of resin. The negative side insulation protruding portion 121B includes a wall portion 131, a flange portion 132, and a standing wall portion 133. The wall portion 131 is disposed around the negative side insertion hole 111B. The flange portion 132 expands from the (+)Y side of the wall portion 131 toward the radially outer side of the negative side insertion hole 111B. The standing wall portion 133 is erected toward the (+)Y side from the radially outer side of the flange portion 132, and a notch 133A is formed in a part of the periphery. The cross-sectional shape of the standing wall portion 133 in the XZ plane is a C shape.

In the present embodiment, since the positive side insulation protruding portion 121A has the same configuration as the negative side insulation protruding portion 121B, explanation thereof will be omitted.

The positive side stator 141A is provided around the positive side insertion hole 111A. The negative side stator 141B is provided around the negative side insertion hole 111B.

The negative side stator 141B is formed of a heat conductive and electrically conductive material. In the present embodiment, the negative side stator 141B is formed of a metal, such as copper. Therefore, the negative side stator 141B serves not only as a temperature measurement terminal for measuring the temperature of the negative terminal 75 but also as a terminal potential measurement terminal for measuring the electric potential of the negative terminal 75.

The positive side stator 141A is formed of an electrically conductive material. In the present embodiment, the positive side stator 141A is formed of a metal, such as copper. Therefore, the positive side stator 141A serves as a terminal potential measurement terminal for measuring the electric potential of the positive terminal 70.

As shown in Fig. 3, the negative side stator 141B is formed in an annular shape. The negative side stator 141B includes a negative side annular portion 142B provided on the bottom surface of the substrate 100 and three negative side pressing portions 143B (pressing portion) formed toward the (+)Y side from the negative side annular portion 142B.

A stator connection end 145 that is formed of a heat conductive material and extends toward the radially outer side of the negative side insertion hole 111B is connected to the negative side annular portion 142B. The stator connection end 145 thermally connects the negative side stator 141B and the temperature measuring element 151, which will be described later, to each other.

As shown in Fig. 5, the negative side pressing portion 143B is formed so as to be closer to the (+)Y side toward the radially inner side of the negative side insertion hole 111B from the negative side annular portion 142B.

When the negative terminal 75 is inserted into the negative side insertion hole 111B, the three negative side pressing portions 143B are elastically deformed so as to expand in the radially outer side of the negative side insertion hole 111B, resulting in a state in which the three negative side pressing portions 143B are disposed along the outer periphery of the negative terminal 75. Accordingly, each of the three negative side pressing portions 143B is in contact with the negative terminal 75, thereby pressing the negative terminal 75 radially inward (toward the inner diameter side). As a result, the negative side stator 141B is attached to the negative terminal 75. The number of negative side pressing portions 143B is not limited to 3. In consideration of the size and the shape of the negative terminal 75, the number of negative side pressing portions 143B can be appropriately determined so that the negative side stator 141B can be more firmly attached to the negative terminal 75.

A recess 146 that is recessed toward the radially outer side of the negative side insertion hole 111B is formed on both sides of the negative side pressing portion 143B in the circumferential direction.

Similar to the negative side stator 141B, the positive side stator 141A includes a positive side annular portion 142A and a positive side pressing portion 143A. In the present embodiment, the positive side stator 141A has the same configuration as the negative side stator 141B except that the stator connection end 145 is not provided in the positive side stator 141A. Therefore, explanation of the positive side stator 141A will be omitted.

As shown in Fig. 3, a temperature measuring element (thermistor) 151 is fixed to a surface on which the battery 2 is disposed, that is, a bottom surface of the top and bottom surfaces of the substrate 100. Although the thermistor is used as a temperature measuring element in the explanation of the present embodiment, the present embodiment is not limited to this. For example, any member that converts measurement data, such as temperature, into an electric signal and outputs the measurement data can be used.

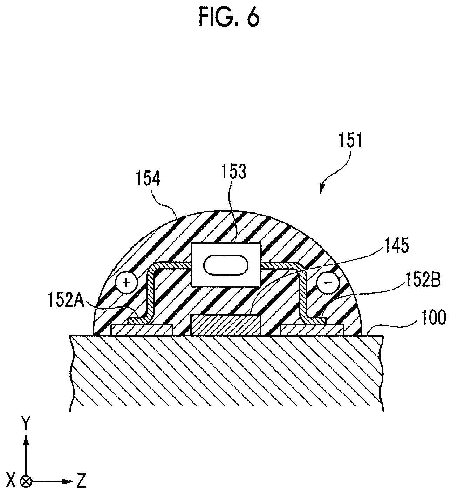

As shown in Fig. 6, the temperature measuring element 151 includes a main body 153 in which a resistor having a resistance value that changes according to temperature is built, a positive side end 152A, and a negative side end 152B. First ends of the positive side end 152A and the negative side end 152B are connected to the main body 153. Second ends of the positive side end 152A and the negative side end 152B are fixed to the bottom surface of the substrate 100. Both of the positive side end 152A and the negative side end 152B are ends for electrically connecting the main body 153 to the outside.

The main body 153 and the stator connection end 145 provided on the substrate 100 are disposed with a gap therebetween. Both of the stator connection end 145 and the temperature measuring element 151 are covered by an insulating material 154. In the present embodiment, silicon is used as an example of the insulating material.

The temperature measuring element 151 and the negative side stator 141B are thermally connected by the stator connection end 145. The temperature measuring element 151 can measure the temperature of the negative terminal 75 through the stator connection end 145 connected to the negative side stator 141B in a state where the negative terminal 75 is inserted into the negative side insertion hole 111B.

Since copper that forms the negative terminal 75 has a higher thermal conductivity than aluminum that forms the positive terminal 70 in the present embodiment, the temperature measuring element 151 is provided on the negative terminal 75 side.

Therefore, when the thermal conductivity of a material that forms the positive terminal 70 is higher than that of a material that forms the negative terminal 75, it is preferable that the temperature measuring element 151 is provided on the positive terminal 70 side.

As shown in Fig. 3, in consideration of the space of the substrate 100, the connector 161 is provided on the side opposite to the temperature measuring element 151 with the safety valve hole 113 interposed therebetween on the substrate 100. In the present embodiment, the connector 161 is provided between the safety valve hole 113 and the positive side insertion hole 111A.

Thus, the temperature measuring element 151, the safety valve hole 113, and the connector 161 are aligned in this order in the (-)X direction. In other words, the arrangement direction from the temperature measuring element 151 to the connector 161 is the (-)X direction. In addition, the connector 161 can be connected to a control device (not shown) through a wiring line (not shown).

A plurality of wiring lines 170 are provided on a surface on which the battery 2 is disposed, that is, a bottom surface of the top and bottom surfaces of the substrate 100. The plurality of wiring lines 170 include a first wiring line 171 connected to the positive side end 152A of the temperature measuring element 151 and a second wiring line 172 connected to the negative side end 152B of the temperature measuring element 151.

The first end of the first wiring line 171 is connected to the positive side end 152A of the temperature measuring element 151 on the substrate 100. The second end of the first wiring line 171 is connected to the connector 161 on the substrate 100. Specifically, the first wiring line 171 includes a wiring portion 171A extending toward the (-)Z side from the positive side end 152A, a wiring portion 171B that has an approximately straight shape and that is bent from the end of the wiring portion 171A and extends toward the (-)X side, and a wiring portion 171C disposed along the arc shape of the safety valve hole 113 from the end of the wiring portion 171B.

The first end of the second wiring line 172 is connected to the negative side end 152B of the temperature measuring element 151 on the substrate 100. The second end of the second wiring line 172 is connected to the connector 161 on the substrate 100. Specifically, the second wiring line 172 includes a wiring portion 172A extending toward the (+)Z side from the negative side end 152B, a wiring portion 172B that has an approximately straight shape and that is bent from the end of the wiring portion 172A and extends toward the (-)X side, and a wiring portion 172C disposed along the arc shape of the safety valve hole 113 from the end of the wiring portion 172B.

Thus, the first wiring line 171 and the second wiring line 172 are disposed along the (-)Z side of the safety valve hole 113 in the substrate 100. The first wiring line 171 and the second wiring line 172 are disposed along the one direction side of the arrangement direction and the perpendicular direction with respect to the safety valve hole 113. The arrangement direction is a direction in which the temperature measuring element 151, the safety valve hole 113, and the connector 161 are aligned.

The wiring portion 171C of the first wiring line 171 and the wiring portion 172C of the second wiring line 172 are disposed so as to be close to each other and approximately parallel to each other.

In addition, the wiring line 170 includes a negative wiring line 173 connected to the stator connection end 145 provided in the negative side annular portion 142B of the negative side stator 141B, a positive wiring line 174 connected to the positive side annular portion 142A of the positive side stator 141A, a battery container wiring line 175 connected to the edge member 115 provided in the through hole for injection 114, and a wiring line 176 for connecting the edge member 115 and the positive side annular portion 142A to each other. A resistor 176A is provided in the wiring line 176.

Here, the positive terminal 70 connected to the positive side stator 141A and the battery case 60 can be made to have approximately the same electric potential by providing the wiring line 176 for connecting the edge member 115 and the positive side annular portion 142A to each other on the substrate 100. Therefore, by making the inner surface of the battery case 60 in contact with the electrolyte be in an oxidizing atmosphere, the electric potential of the battery case 60 can be maintained in the electric potential range that can prevent alloying to LiAl with lithium ions.

By providing the resistor 176A, for example, even if an abnormality, such as short-circuiting between the negative terminal 75 and the battery case 60, occurs, a current flowing from the positive terminal 70 to the battery case 60 can be limited to a small current, for example, to the mA order. The resistance value of the resistor 176A (pull-up resistor) can be appropriately set freely in consideration of a current value that may flow to the battery 2. For example, it is possible to use a resistor of 1 kΩ.

In the present embodiment, the negative wiring line 173 and the positive wiring line 174 are provided on the substrate 100 in order to measure the terminal potential using the positive side stator 141A and the negative side stator 141B. However, the embodiment of the present invention is not limited to this, and the negative wiring line 173 and the positive wiring line 174 can also be omitted. The battery container wiring line 175 may be similarly omitted.

Next, the bus bar 4 will be described.

As shown in Figs. 1 and 5, the bus bar 4 is a member for electrically connecting the electrodes of the adjacent batteries 2 to each other. A through hole 4A through which a bolt 4X passes is formed in the bus bar 4. The through hole 4A is formed at a position corresponding to each of the positive terminal 70 and the negative terminal 75 of the battery 2. The bus bar 4 is connected to the electrode of the battery 2 by inserting the bolt 4X into the through hole 4A so that the bolt 4X is screwed to the female screws 70X and 75X formed in the positive terminal 70 or the negative terminal 75.

Next, assembling of the battery module 1 configured as described above will be described.

First, the battery state monitoring device 3 is disposed on the (+)Y side of the battery 2 such that the positive side insertion hole 111A formed in the battery state monitoring device 3 faces the positive terminal 70 of the battery 2, the negative side insertion hole 111B faces the negative terminal 75, and the safety valve hole 113 faces the safety valve 78 of the battery 2.

In this case, since the positive side pressing portion 143A is formed toward the (+)Y side from the positive side annular portion 142A, the positive side pressing portion 143A and the positive terminal 70 correspond to each other. Since the negative side pressing portion 143B is formed toward the (+)Y side from the negative side annular portion 142B, the negative side pressing portion 143B and the negative terminal 75 correspond to each other. As a result, the substrate 100 is positioned with respect to the battery 2. The positive terminal 70 can be reliably and easily positioned with respect to the positive side insertion hole 111A so as to be easily inserted thereinto, and the negative terminal 75 can be reliably and easily positioned with respect to the negative side insertion hole 111B so as to be easily inserted thereinto.

In this state, the positive terminal 70 is inserted into the positive side insertion hole 111A, and the negative terminal 75 is inserted into the negative side insertion hole 111B. In this case, the three negative side pressing portions 143B of the negative side stator 141B are elastically deformed so as to expand in the radially outer side of the negative side insertion hole 111B. Accordingly, each of the three negative side pressing portions 143B is in contact with the negative terminal 75, thereby pressing the negative terminal 75 toward the radially inner side of the negative side insertion hole 111B. As a result, the negative side stator 141B can be attached to the negative terminal 75.

Here, when inserting the negative terminal 75 into the negative side insertion hole 111B, the negative side pressing portion 143B of the negative side stator 141B moves in the (-)Y direction while being in contact with the outer peripheral surface of the negative terminal 75. Therefore, even if there is foreign matter or the like on the outer peripheral surface of the negative terminal 75 of the battery 2, the foreign matter is removed from the outer peripheral surface of the negative terminal 75 along with the contact movement of the negative side pressing portion 143B.

Similarly, the positive side pressing portion 143A of the positive side stator 141A also presses the positive terminal 70 toward the radially inner direction.

In addition, a bolt (not shown) is screwed into the female screw 151A of the edge member 115 provided in the through hole for injection 114 formed in the substrate 100 and the female screw 68A of the bolt 68 screwed to the inlet 66 of the battery case 60. As a result, the battery state monitoring device 3 is attached to the battery 2.

In a state in which the battery state monitoring device 3 is attached to the battery 2, the negative side stator 141B formed of a heat conductive material is attached to the negative terminal 75 on the negative terminal 75 side. The stator connection end 145 that is connected to the negative side annular portion 142B of the negative side stator 141B and is formed of a heat conductive material thermally connects the temperature measuring element 151 and the negative side stator 141B to each other. Accordingly, the negative terminal 75 and the temperature measuring element 151 are thermally connected to each other through the negative side stator 141B and the stator connection end 145.

In addition, the negative side stator 141B is formed of an electrically conductive material. Accordingly, the negative terminal 75 and the connector 161 are electrically connected to each other through the negative side stator 141B and the negative wiring line 173.

On the positive terminal 70 side, the positive side stator 141A formed of an electrically conductive material is attached to the positive terminal 70. Accordingly, the positive terminal 70 and the connector 161 are electrically connected to each other through the positive side stator 141A and the positive wiring line 174.

The battery case 60 and the connector 161 are electrically connected to each other through the bolt 68 screwed into the inlet 66, the edge member 115 provided on the substrate 100 and formed of a conductor, and the wiring line 170 and a bolt (not shown) screwed into the female screw 68A of the bolt 68 and the female screw 115A of the edge member 115.

Then, the connector 161 of the battery state monitoring device 3 attached to the battery 2 and a control device (not shown) are connected to each other through a wiring line.

Then, a plurality of batteries 2 are disposed and the bolt 4X is inserted into the through hole 4A formed in the bus bar 4, so that the bolt 4X is screwed into the female screws 70X and 75X formed in the positive terminal 70 and the negative terminal 75 of the battery 2. Thus, the battery module 1 is assembled.

In the battery module 1 configured in this manner, the negative side stator 141B is attached to the negative terminal 75 by inserting the negative terminal 75 into the negative side insertion hole 111B. In addition, the negative terminal 75 and the temperature measuring element 151 are thermally connected to each other.

Since the negative side pressing portion 143B of the negative side stator 141B presses the negative terminal 75 toward the radially inner side of the negative side insertion hole 111B, it is possible to maintain a fixed state of the negative side pressing portion 143B and the negative terminal 75 and to increase the contact between the negative side pressing portion 143B and the negative terminal 75.

In addition, since the three negative side pressing portions 143B of the negative side stator 141B are disposed along the outer periphery of the negative terminal 75, the three negative side pressing portions 143B reliably press the negative terminal 75 in the circumferential direction.

Accordingly, for example, even if vibration occurs in the battery 2, the relative positional relationship among the negative terminal 75, the negative side stator 141B, and the temperature measuring element 151 is not changed. Therefore, it is possible to stably and accurately measure the inside temperature of the negative terminal 75 and thus the battery 2.

In the device disclosed in PTL 1, the thermistor is biased to the battery can side by the sponge, thereby measuring the temperature of the battery. Therefore, for example, in the case of attaching a device to a battery can when there is foreign matter on the battery can, it is not possible to accurately measure the temperature of the battery because foreign matter is interposed between the battery can and the sponge. On the other hand, in the battery state monitoring device 3 according to the present embodiment, even if there is foreign matter or the like on the outer peripheral surface of the negative terminal 75 as described above, the foreign matter is removed along with the contact movement between the negative side pressing portion 143B and the negative terminal 75. Therefore, the battery state monitoring device 3 can accurately measure the temperature of the negative terminal 75 and thus the inside temperature of the battery 2.

In addition, the temperature measuring element 151 is connected to the negative terminal 75 through the negative side stator 141B that is a conductor. Therefore, since the temperature of the negative terminal 75 can be measured, the inside temperature of the battery 2 can be recognized more accurately than in a case where the temperature measuring element is connected to the surface of the battery case.

In addition, since the positive terminal 70 and the negative terminal 75 are electrically connected to the connector 161 through the positive terminal 70, the negative terminal 75, the positive wiring line 174, and the negative wiring line 173, it is possible to recognize the voltage between the positive terminal 70 and the negative terminal 75.

In addition, the battery case 60 and the connector 161 are electrically connected to each other through the bolt 68 screwed into the inlet 66, the edge member 115 provided on the substrate 100 and formed of a conductor, and the wiring line 170 and a bolt (not shown) screwed into the female screw 68A of the bolt 68 and the female screw 115A of the edge member 115. Accordingly, it is possible to recognize the electric potential of the battery case 60.

The negative side stator 141B serves as a temperature measurement terminal for measuring the temperature of the negative terminal 75 and also serves as a terminal potential measurement terminal for measuring the electric potential of the negative terminal 75. Therefore, it is possible to reduce the number of parts of the measuring device compared with a case where the temperature measurement terminal and the terminal potential measurement terminal are provided separately.

In addition, since the above-described work is only for inserting the negative terminal 75 (positive terminal 70) into the negative side insertion hole 111B (positive side insertion hole 111A), it is possible to measure the temperature of the battery 2, the voltage between the positive terminal 70 and the negative terminal 75, and the electric potential of the battery case 60 with easy work.

In addition, since the temperature measuring element 151 is provided on the bottom surface of the substrate 100, there is no possibility that the temperature measuring element 151 will be damaged due to being in contact with the bus bar 4 when attaching the bus bar 4 to the surface of the substrate 100. Therefore, it is possible to maintain the healthy state of the temperature measuring element 151.

In addition, since the negative side stator 141B is covered by the insulating material 154, it is possible to maintain the insulation state and to measure the temperature or the like of the battery 2 without being influenced by the cooling air for cooling the battery, for example.

Various shapes or combinations of respective components illustrated in the above-described embodiments are examples, and various changes can be made depending on design requirements or the like without departing from the scope of the present invention as defined in the appended claims. Hereinafter, various modification examples of the above embodiment will be described.

### [First modification example]

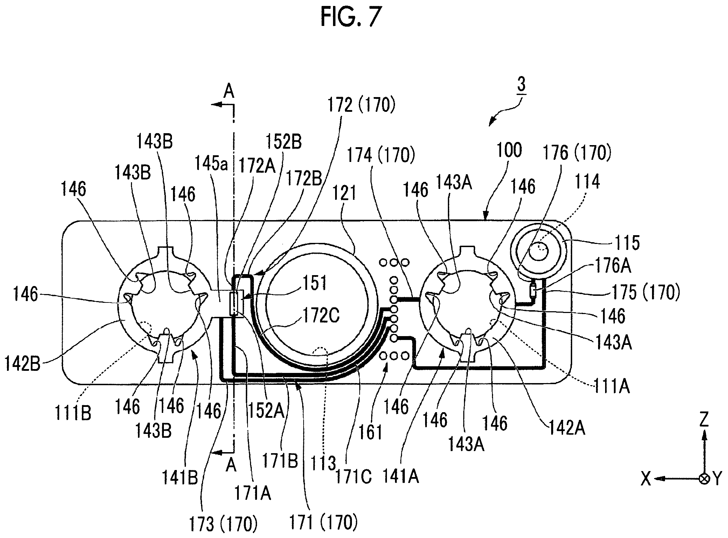

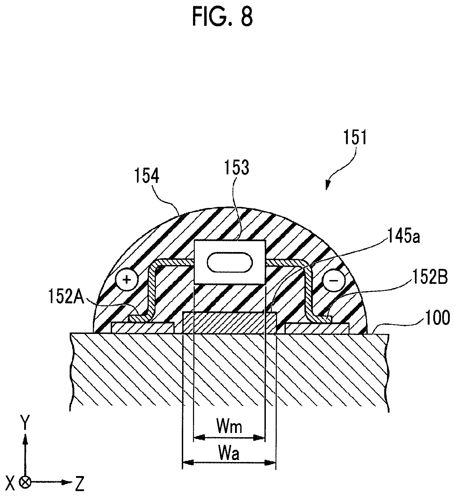

A first modification example of the above embodiment will be described with reference to Figs. 7 and 8.

In this modification example, the width of a stator connection end 145a extending from the negative side annular portion 142B of the negative side stator 141B is increased. The width of the stator connection end 145a is a width in a direction parallel to the substrate 100 and in a Z direction perpendicular to the X direction in which the stator connection end 145a extends. In this modification example, the width Wa of the stator connection end 145a is larger than the maximum size Wm in the main body 153 of the temperature measuring element 151. The thickness of the stator connection end 145a is almost the same as the thickness of the stator connection end 145 in the embodiment described above.

Thus, since the thermal resistance of the stator connection end 145a is reduced by increasing the width of the stator connection end 145a, heat is easily transferred from the negative terminal 75 to the temperature measuring element 151 through the stator connection end 145a. Accordingly, it is possible to reduce the time difference of the temperature change around the temperature measuring element 151 with respect to the temperature change of the negative terminal 75. Therefore, in this modification example, it is possible to improve the temperature measurement responsiveness.

In this modification example, the amount of heat flowing from the negative terminal 75 to the temperature measuring element 151 side is increased.

Therefore, in this modification example, it is possible to reduce the influence of external environmental temperature compared with a case where the width of the stator connection end is small. In the battery 2 described above, since the amount of heat generated around the electrode terminals 70 and 75 is large, the substrate 100 side of the battery 2 is actively cooled in many cases. Thus, even when cooling the substrate 100 side of the battery 2, a value closer to the actual temperature can be obtained as the temperature value of the negative terminal 75 by suppressing the influence of cooling in this modification example.

### [Second modification example]

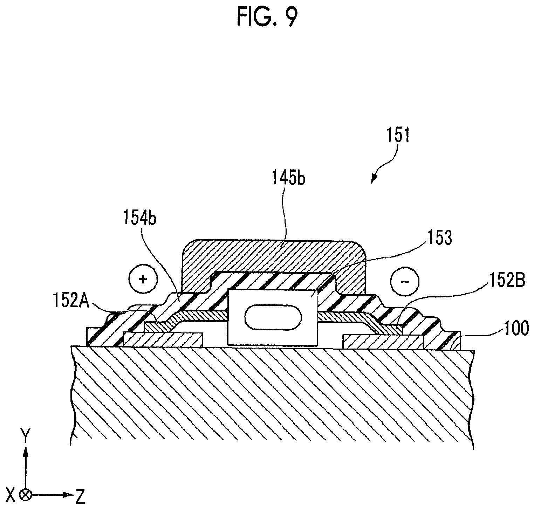

A second modification example of the above embodiment will be described with reference to Fig. 9.

In the embodiment described above, as shown in Fig. 6, the substrate 100, the stator connection end 145, the insulating material 154, and the temperature measuring element 151 (main body 153) are aligned in this order in the Y direction that is the thickness direction of the substrate 100. In this modification example, the substrate 100, the temperature measuring element 151 (main body 153), an insulating film 154b that is an insulating material, and a stator connection end 145b are aligned in this order in the Y direction that is the thickness direction of the substrate 100. That is, the stator connection end 145b in this modification example is disposed on the side opposite to the substrate 100 side with respect to the temperature measuring element 151 with the insulating film 154b that is an insulating material interposed therebetween. Also in this modification example, the width of the stator connection end 145b is larger than the maximum size in the main body 153 of the temperature measuring element 151.

In this modification example, since the temperature measuring element 151 is interposed between the substrate 100 and the stator connection end 145b, it is possible to reduce the influence of the external environmental temperature more than in the embodiment and the first modification example described above.

In addition, although the outside of the stator connection end 145b is not covered by an insulating material in this modification example, the outside of the stator connection end 145b may be covered by an insulating material as in the embodiment or the first modification example described above.

### [Third modification example]

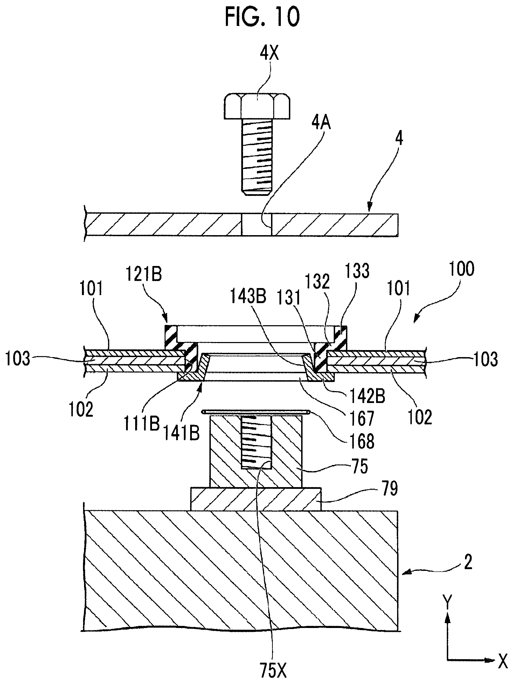

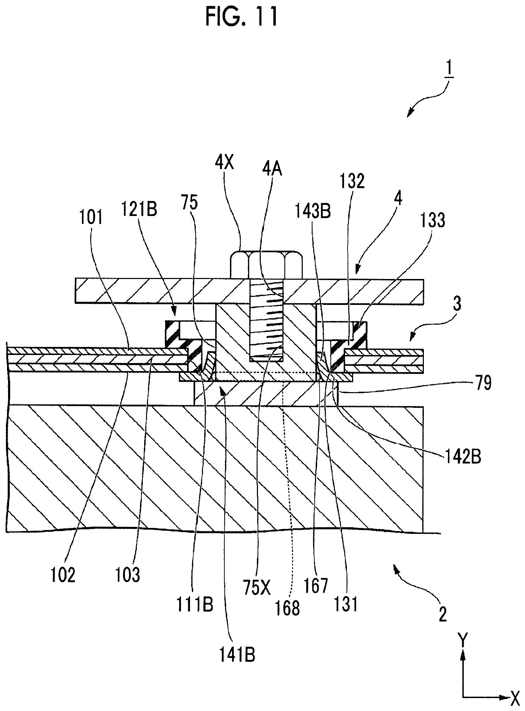

A third modification example of the above embodiment will be described with reference to Figs. 10 and 11.

In this modification example, between the outer peripheral side of the cylindrical negative terminal 75 and the inner peripheral side of the annular negative side stator 141B, a thermal conduction promoting member 168 to facilitate heat conduction therebetween is disposed. A gap portion 167 is present between the outer peripheral side of the cylindrical negative terminal 75 and the inner peripheral side of the annular negative side stator 141B, so that the outer peripheral side of the cylindrical negative terminal 75 and the inner peripheral side of the annular negative side stator 141B face each other in a state of being separated from each other. The thermal conduction promoting member 168 is disposed so as to be in contact with both of the negative terminal 75 and the negative side stator 141B in the gap portion 167.

The thermal conduction promoting member 168 is formed of a heat conductive material having a lower melting point than the melting point of the negative terminal 75 and the melting point of the negative side stator 141B. For example, when the negative terminal 75 and the negative side stator 141B are formed of copper or an alloy containing copper as a main component, the melting point of copper is 1083°C, and the melting point of an alloy containing copper as a main component is, for example, 897°C to 1097°C even though it depends on an additive. The thermal conduction promoting member 168 is formed of a low melting point alloy having a melting point of 200°C or lower, for example.

Examples of the low melting point alloy include not only Sn, which is a main component of the solder, but also an alloy containing Bi, In, or the like. Specifically, for example, there are the following alloys. The melting point shown below is a temperature at which the solid starts to melt; a so-called solidus temperature. In addition, even if the components of the metal elements forming the alloy are the same, the melting point changes if the component ratio shown below changes.

28.5 wt% Sn-Pb - 28.5 wt% Bi (melting point: 99°C)
46 wt% Sn-Pb - 14 wt% Bi (melting point: 137°C)
46 wt% Sn-Pb - 8 wt% Bi (melting point: 135°C)
19 wt% Sn-Pb - 53.5 wt% Bi - 10.5 wt% In (melting point: 60°C)
13.3 wt% Sn-Pb - 50 wt% Bi - 10 wt% Cd (wood metal) (melting point: 70°C)
12.5 wt% Sn-Pb - 50 wt% Bi - 12.5 wt% Cd (melting point: 60.5°C)
43 wt% Sn - 57 wt% Bi (melting point: 138°C)
48 wt% Sn - 52 wt% In (melting point: 117°C)

In this modification example, since the thermal conduction promoting member 168 formed of a heat conductive material is disposed in the gap portion 167 between the negative terminal 75 and the negative side stator 141B, heat can be easily transferred from the negative terminal 75 to the negative side stator 141B. In addition, since the thermal conduction promoting member 168 has a low melting point, the thermal conduction promoting member 168 becomes soft in an early stage of the process in which the temperature of the negative terminal 75 rises. Therefore, since the contact between the thermal conduction promoting member 168 and the negative terminal 75, and thermal conduction promoting member 168 and the negative side stator 141B is increased, heat can be more easily transferred from the negative terminal 75 to the negative side stator 141B.

Here, if the temperature of the negative terminal 75 becomes 100°C (hereinafter, this temperature is referred to as a limit temperature) or higher, it is assumed that the battery is unusable or the capability has significantly decreased hereinafter.

In such a case, it is preferable to detect this before the temperature of the negative electrode reaches 100°C.

Therefore, in this modification example, the thermal conduction promoting member 168 is formed of a material whose melting point is a temperature lower than the limit temperature of the negative terminal 75. For this reason, in this modification example, the thermal conduction promoting member 168 starts to melt before the negative terminal 75 reaches the limit temperature, thereby increasing the thermal conductivity between the negative terminal 75 and the negative side stator 141B. As a result, it is possible to improve the temperature measurement responsiveness.

As a material forming the thermal conduction promoting member 168, a material having a melting point equal to or higher than the limit temperature of the negative terminal 75 may be used, or a material that has a melting point lower than the limit temperature of the negative terminal 75 and becomes soft to some extent may be used. As described above, this is because the thermal conduction promoting member 168 becomes soft to increase the contact between the thermal conduction promoting member 168 and the negative terminal 75, and the thermal conduction promoting member 168 and the negative side stator 141B, and accordingly, the thermal conductivity between the negative terminal 75 and the negative side stator 141B is increased.

### [Other modification examples]

Although the lithium secondary battery has been described as an example of the battery 2 in the present embodiment shown above, the embodiment of the present invention is not limited to this. Any battery in which an electrode terminal is disposed on one surface of the battery case may be used, and the type and the shape of a battery can be appropriately changed.

In the present embodiment, the case where the stators 141A and 141B include the pressing portions 143A and 143B that press the electrode terminals 70 and 75 radially inward so as to be in contact with the electrode terminals 70 and 75 in a state where the electrode terminals 70 and 75 are inserted into the terminal insertion holes 111A and 111B has been described as an example. However, the embodiment of the present invention is not limited to this, and the stator may be fixed to the electrode terminal so as to be in contact with the electrode terminal in a state where the electrode terminal is inserted into the terminal insertion hole, and may have a shape according to the shape of the electrode terminal.

In the present embodiment, the case where the temperature measuring element 151 is provided on the surface (bottom layer 102) facing the battery 2 of one of the top and bottom surfaces of the substrate 100 has been described as an example. However, the temperature measuring element 151 may be provided on the top surface (surface layer 101) of the substrate 100.

In the present embodiment, the case where the stator connection end 145 that is formed of a heat conductive material, is connected to the stators 141A and 141B, and thermally connects the stators 141A and 141B to the temperature measuring element 151 has been described as an example. However, the stator connection end 145 may be omitted, and the temperature measuring element 151 may be directly connected to the stator 141.

In the present embodiment, the case where both of the temperature measuring element 151 and the stator connection end 145 are covered by an insulating material has been described as an example. However, the insulating material may be omitted when it is possible to measure the temperature without receiving the influence from the outside or the like.

In the present embodiment, the case where the stators 141A and 141B are formed of an electrically conductive material and include a terminal for terminal potential measurement for measuring the electric potentials of the electrode terminals 70 and 75 has been described as an example. However, the terminal for terminal potential measurement may be omitted when measuring only the temperature.

### Industrial Applicability

According to the battery state monitoring device and the battery module including the same described above, it is possible to measure the temperature of the battery stably and accurately.

### Reference Signs List

1: battery module
2: battery
3: battery state monitoring device
75: negative terminal (electrode terminal)
100: substrate
111B: negative side insertion hole (terminal insertion hole)
141B: negative side stator (stator)
143B: negative side pressing portion (pressing portion)
145, 145a, 145b: stator connection end
151: temperature measuring element
154: insulating material
154b: insulating film (insulating material)
167: gap portion
168: thermal conduction promoting member

## Claims

1. A battery state monitoring device (3), comprising:
a substrate (100) in which a terminal insertion hole (111B) is formed, an electrode terminal (75) of a battery (2) being inserted into the terminal insertion hole (111B);
a stator (141B) that is formed of a heat conductive material, is provided around the terminal insertion hole (111B), and is attached to the electrode terminal (75) so as to be in contact with the electrode terminal in a state where the electrode terminal is inserted into the terminal insertion hole (111B); and
a temperature measuring element (151) that is fixed to the substrate (100) and measures a temperature of the electrode terminal (75) through the stator (141B), **characterized in that**
the stator (141B) includes a pressing portion (143B) that presses the electrode terminal (75) radially inward so as to be in contact with the electrode terminal in a state where the electrode terminal (75) is inserted into the terminal insertion hole (111B).

2. The battery state monitoring device (3) according to claim 1,
wherein the stator (141B) includes three pressing portions that are disposed along an outer periphery of the electrode terminal (75) in a state where the electrode terminal (75) is inserted into the terminal insertion hole (111B) .

3. The battery state monitoring device (3) according to claim 1 or 2, wherein the temperature measuring element is provided on a surface facing the battery (2) of one of a top and bottom surfaces of the substrate (100).

4. The battery state monitoring device (3) according to any one of claims 1 to 3, further comprising:
a stator connection end (145, 145a, 145b) that is formed of a heat conductive material, is connected to the stator (141B), and thermally connects the stator (141B) and the temperature measuring element (151) to each other,
wherein both of the temperature measuring element (151) and the stator connection end (145, 145a, 145b) are covered by an insulating material (154).

5. The battery state monitoring device (3) according to any one of claims 1 to 3, further comprising:
a stator connection end (145, 145a, 145b) that is formed of a heat conductive material, is connected to the stator (141B), and thermally connects the stator (141B) and the temperature measuring element (151) to each other,
wherein the stator connection end (145, 145a, 145b) is disposed on a side of the substrate (100) with respect to the temperature measuring element (151) in a thickness direction of the substrate (100), with an insulating material (154) interposed therebetween.

6. The battery state monitoring device (3) according to any one of claims 1 to 3, further comprising:
a stator connection end (145, 145a, 145b) that is formed of a heat conductive material, is connected to the stator (141B), and thermally connects the stator (141B) and the temperature measuring element (151) to each other,
wherein the stator connection end (145, 145a, 145b) is disposed on a side opposite to a side of the substrate (100) with respect to the temperature measuring element (151) in a thickness direction of the substrate (100), with an insulating material (154) interposed therebetween.

7. The battery state monitoring device (3) according to any one of claims 4 to 6,
wherein the temperature measuring element (151) includes a main body and an end for connecting the main body to an outside, and
a width of the stator connection end (145, 145a, 145b) in a direction parallel to the substrate (100) is larger than a maximum size of the main body in the temperature measuring element (151).

8. The battery state monitoring device (3) according to any one of claims 1 to 7,
wherein a gap portion (167) is present between the electrode terminal (75) and the stator (141B), the electrode terminal (75) and the stator (141B) facing each other so as to be separated from each other with the gap interposed therebetween, and
a thermal conduction promoting member (168) that is disposed in the gap portion (167), is in contact with both of the electrode terminal (75) and the stator (141B), and is formed of a heat conductive material having a lower melting point than melting points of the electrode terminal (75) and the stator (141B) is provided.

9. The battery state monitoring device (3) according to claim 8,
wherein the thermal conduction promoting member (168) is formed of an alloy containing Sn and Bi or In.

10. The battery state monitoring device (3) according to any one of claims 1 to 9,
wherein the stator (141B) is formed of an electrically conductive material, and forms a terminal for terminal potential measurement for measuring an electric potential of the electrode terminal (75).

11. An battery module (1), comprising:
the battery state monitoring device (3) according to any one of claims 1 to 10; and
the battery (2).

## Patentansprüche

1. Batteriezustandsüberwachungsvorrichtung (3), umfassend:
ein Substrat (100), in dem ein Terminal-Einführungsloch (111B) gebildet ist, wobei ein Elektrodenterminal (75) einer Batterie (2) in das Terminal-Einführungsloch (111B) eingeführt wird;
einen Stator (141B), der aus einem wärmeleitfähigen Material gebildet ist, und der rund um das Terminal-Einführungsloch (111B) vorgesehen ist und am Elektrodenterminal (75) befestigt ist, um so in Kontakt mit dem Elektrodenterminal in einem Zustand zu sein, wo das Elektrodenterminal in das Terminal-Einführungsloch (111B) eingeführt wird; und
ein Temperaturmesselement (151), das am Substrat (100) befestigt ist und eine Temperatur des Elektrodenterminals (75) durch den Stator (141B) misst, **dadurch gekennzeichnet, dass**
der Stator (141B) einen Druckabschnitt (143B) umfasst, der das Elektrodenterminal (75) radial nach innen drückt, um so in Kontakt mit dem Elektrodenterminal in einem Zustand zu sein, wo das Elektrodenterminal (75) in das Terminal-Einführungsloch (111B) eingeführt wird.

2. Batteriezustandsüberwachungsvorrichtung (3) nach Anspruch 1,
wobei der Stator (141B) drei Druckabschnitte umfasst, die entlang einer äußeren Peripherie des Elektrodenterminals (75) in einem Zustand angeordnet sind, wo das Elektrodenterminal (75) in das Terminal-Einführungsloch (111B) eingeführt wird.

3. Batteriezustandsüberwachungsvorrichtung (3) nach Anspruch 1 oder 2,
wobei das Temperaturmesselement auf einer Fläche vorgesehen ist, die der Batterie (2) von einer Fläche aus einer oberen und unteren Fläche des Substrats (100) zugewandt ist.

4. Batteriezustandsüberwachungsvorrichtung (3) nach einem der Ansprüche 1 bis 3, weiter umfassend:
ein Statorverbindungsende (145, 145a, 145b), das aus einem wärmeleitenden Material gebildet wird, ist mit dem Stator (141B) verbunden und verbindet thermisch den Stator (141B) und das Temperaturmesselement (151) miteinander,
wobei sowohl das Temperaturmesselement (151) als auch das Statorverbindungsende (145, 145a, 145b) durch ein Isoliermaterial (154) abgedeckt sind.

5. Batteriezustandsüberwachungsvorrichtung (3) nach einem der Ansprüche 1 bis 3, weiter umfassend:
ein Statorverbindungsende (145, 145a, 145b), das aus einem wärmeleitenden Material gebildet wird, ist mit dem Stator (141B) verbunden und verbindet thermisch den Stator (141B) und das Temperaturmesselement (151) miteinander,
wobei das Statorverbindungsende (145, 145a, 145b) auf einer Seite des Substrats (100) mit Bezug auf das Temperaturmesselement (151) in einer Dickenrichtung des Substrats (100) angeordnet ist, wobei ein Isoliermaterial (154) dazwischen angeordnet ist.

6. Batteriezustandsüberwachungsvorrichtung (3) nach einem der Ansprüche 1 bis 3, weiter umfassend:
ein Statorverbindungsende (145, 145a, 145b), aus einem wärmeleitenden Material gebildet, ist mit dem Stator (141B) verbunden und verbindet thermisch den Stator (141B) und das Temperaturmesselement (151) miteinander,
wobei das Statorverbindungsende (145, 145a, 145b) auf einer entgegengesetzten Seite des Substrats (100) mit Bezug auf das Temperaturmesselement (151) in einer Dickenrichtung des Substrats (100) angeordnet ist, wobei ein Isoliermaterial (154) dazwischen angeordnet ist.

7. Batteriezustandsüberwachungsvorrichtung (3) nach einem der Ansprüche 4 bis 6,
wobei das Temperaturmesselement (151) einen Grundkörper und ein Ende zum Verbinden des Grundkörpers mit einer Außenseite beinhaltet, und
eine Breite des Statorverbindungsendes (145, 145a, 145b) in einer Richtung parallel zum Substrat (100) ist größer als eine Maximalgröße des Grundkörpers im Temperaturmesselement (151).

8. Batteriezustandsüberwachungsvorrichtung (3) nach einem der Ansprüche 1 bis 7,
wobei ein Spaltbereich (167) zwischen dem Elektrodenterminal (75) und dem Stator (141B) vorhanden ist, wobei das Elektrodenterminal (75) und der Stator (141B) einander zugewandt sind, so dass sie mit dem dazwischen liegenden Spalt voneinander getrennt sind, und
ein Wärmeleitungsförderelement (168), das im Spaltbereich (167) angeordnet ist, ist in Kontakt sowohl mit dem Elektrodenterminal (75) als auch dem Stator (141B) und ist aus einem wärmeleitenden Material vorgesehen, das einen niedrigeren Schmelzpunkt als die Schmelzpunkte des Elektrodenterminals (75) und des Stators (141B) hat.

9. Batteriezustandsüberwachungsvorrichtung (3) nach Anspruch 8,
wobei das Wärmeleitungsförderelement (168) aus einer Legierung gebildet ist, die Sn und Bi oder In enthält.

10. Batteriezustandsüberwachungsvorrichtung (3) nach einem der Ansprüche 1 bis 9,
wobei der Stator (141B) aus einem elektrisch leitfähigen Material gebildet ist und ein Terminal zur Terminalpotentialmessung zum Messen eines elektrischen Potentials des Elektrodenterminals (75) bildet.

11. Batteriemodul (1), umfassend:
Batteriezustandsüberwachungsvorrichtung (3) nach einem die Ansprüche 1 bis 10; und
die Batterie (2).

## Revendications

1. Dispositif de contrôle d'état de batterie (3), comprenant :
un substrat (100) dans lequel un trou d'insertion de borne (111B) est formé, une borne d'électrode (75) d'une batterie (2) étant insérée dans le trou d'insertion de borne(111B) ;
un stator (141B) qui est formé d'une matière conductrice de chaleur, est prévu autour du trou d'insertion de borne (111B), et est attaché à la borne d'électrode (75) afin d'être en contact avec la borne d'électrode dans un état où la borne d'électrode est insérée dans le trou d'insertion de borne (111B) ; et
un élément de mesure de température (151) qui est fixé au substrat (100) et qui mesure une température de la borne d'électrode (75) à travers le stator (141B), **caractérisé en ce que**
le stator (141B) inclut une portion de pression (143B) qui presse la borne d'électrode (75) de façon radiale vers l'intérieur afin d'être en contact avec la borne d'électrode dans un état où la borne d'électrode (75) est insérée dans le trou d'insertion de borne (111B).

2. Dispositif de contrôle d'état de batterie (3) selon la revendication 1,
dans lequel le stator (141B) inclut trois portions de pression qui sont disposées le long d'une périphérie extérieure de la borne d'électrode (75) dans un état où la borne d'électrode (75) est insérée dans le trou d'insertion de borne (111B).

3. Dispositif de contrôle d'état de batterie (3) selon la revendication 1 ou 2,
dans lequel l'élément de mesure de température est prévu sur une surface faisant face à la batterie (2) de l'une d'une surface supérieure et d'une surface inférieure du substrat (100).

4. Dispositif de contrôle d'état de batterie (3) selon l'une quelconque des revendications 1 à 3, comprenant en outre :
une extrémité de connexion de stator (145, 145a, 145b) qui est formée d'une matière conductrice de chaleur, est reliée au stator (141B), et relie thermiquement le stator (141B) et l'élément de mesure de température (151) l'un à l'autre,
dans lequel les deux de l'élément de mesure de température (151) et de l'extrémité de connexion de stator (145, 145a, 145b) sont recouverts par un matériau isolant (154).

5. Dispositif de contrôle d'état de batterie (3) selon l'une quelconque des revendications 1 à 3, comprenant en outre :
une extrémité de connexion de stator (145, 145a, 145b) qui est formée d'une matière conductrice de chaleur, est reliée au stator (141B) et relie thermiquement le stator (141B) et l'élément de mesure de température (151) l'un à l'autre,
dans lequel l'extrémité de connexion de stator (145, 145a, 145b) est disposée sur un côté du substrat (100) par rapport à l'élément de mesure de température (151) dans une direction d'épaisseur du substrat (100), avec une matière isolante (154) interposée entre ces derniers.

6. Dispositif de contrôle d'état de batterie (3) selon l'une quelconque des revendications 1 à 3, comprenant en outre :
une extrémité de connexion de stator (145, 145a, 145b) qui est formée d'une matière conductrice de chaleur, est reliée au stator (141B) et relie thermiquement le stator (141B) et l'élément de mesure de température (151) l'un à l'autre,
dans lequel l'extrémité de connexion de stator (145, 145a, 145b) est disposée sur un côté opposé à un côté du substrat (100) par rapport à l'élément de mesure de température (151) dans une direction d'épaisseur du substrat (100), avec une matière isolante (154) interposée entre ces derniers.

7. Dispositif de contrôle d'état de batterie (3) selon l'une quelconque des revendications 4 à 6,
dans lequel l'élément de mesure de température (151) inclut un corps principal et une extrémité pour relier le corps principal à un extérieur, et
une largeur de l'extrémité de connexion de stator (145, 145a, 145b) dans une direction parallèle au substrat (100) est plus grande qu'une taille maximale du corps principal dans l'élément de mesure de température (151).

8. Dispositif de contrôle d'état de batterie (3) selon l'une quelconque des revendications 1 à 7,
dans lequel une portion d'espacement (167) est présente entre la borne d'électrode (75) et le stator (141B), la borne d'électrode (75) et le stator (141B) se faisant face afin d'être séparés l'un de l'autre avec l'espacement interposé entre ces derniers, et
un élément favorisant la conduction thermique (168) qui est disposé dans la portion d'espacement (167), est en contact avec les deux de la borne d'électrode (75) et du stator (141B) et est formé d'une matière conductrice de chaleur ayant un point de fusion inférieur aux points de fusion de la borne d'électrode (75) et le stator (141B) est prévu.

9. Dispositif de contrôle d'état de batterie (3) selon la revendication 8,
dans lequel l'élément favorisant la conduction thermique (168) est formé d'un alliage contenant du Sn et du Bi ou de l'In.

10. Dispositif de contrôle d'état de batterie (3) selon l'une quelconque des revendications 1 à 9,
dans lequel le stator (141B) est formé d'une matière électriquement conductrice et forme une borne pour la mesure de potentiel de borne pour mesurer un potentiel électrique de la borne d'électrode (75).

11. Module de batterie (1), comprenant :
le dispositif de contrôle d'état de batterie (3) selon l'une quelconque des revendications 1 à 10 ; et
la batterie (2).
